(19) Europäisches Patentamt
European Patent Office
Office européen des brevets

(11) Publication number: **0 231 548 B1**

(12) **EUROPEAN PATENT SPECIFICATION**

(45) Date of publication of patent specification: **12.06.91**

(51) Int. Cl.$^5$: **C08F 283/00**, C08G 18/48, H05K 3/28, B05D 3/06, B05D 7/24

(21) Application number: **86202264.7**

(22) Date of filing: **20.10.83**

(60) Publication number of the earlier application in accordance with Art.76 EPC: **0 112 005**

The file contains technical information submitted after the application was filed and not included in this specification

(54) **Conformal coating and potting system.**

(30) Priority: **12.11.82 US 441164**
**12.11.82 US 441165**
**31.08.83 US 528286**

(43) Date of publication of application:
**12.08.87 Bulletin 87/33**

(45) Publication of the grant of the patent:
**12.06.91 Bulletin 91/24**

(84) Designated Contracting States:
**AT BE CH DE FR GB IT LI NL SE**

(56) References cited:
**US-A- 3 396 210**
**US-A- 3 968 089**
**US-A- 4 131 602**
**US-A- 4 174 307**

(73) Proprietor: **LOCTITE CORPORATION**
**705 North Mountain Road**
**Newington, Connecticut 06111(US)**

(72) Inventor: **Nativi, Terry A.**
**126 Ridgewood Drive**
**Rocky Hill, CT 06067(US)**
Inventor: **Kadziela, Kris**
**190 Jerry Road**
**East Hartford, CT 06118(US)**

(74) Representative: **Marchant, James Ian et al**
**Elkington and Fife Beacon House 113 Kingsway**
**London WC2B 6PP(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services

## Description

This invention concerns polymerizable compositions which have their primary utility in the area of coatings and sealants. The invention has particular utility in the area of conformal coatings for printed circuit boards and pottings for electrical and electronic components and will be described in connection with such utility, although other uses are contemplated.

Printed circuit boards and electrical and electronic components may be coated or potted with a protective film to avoid or at least minimize degradation in electrical performance due to contamination. The most damaging, and usually the most prevalent contaminant generally is considered to be moisture or humidity. Excessive moisture or humidity will drastically lower insulation resistance between conductors, accelerate high-voltage breakdown and dendritic growth, and corrode conductors. Other contaminants which may damage printed circuit boards and components include various chemicals which may be residues of the manufacturing process such as fluxes, organic solvents, release agents, metal particles and marking inks, and contaminants which inadvertently may be deposited by human handling such as body greases, fingerprints, cosmetics and food stains. Ambient operating conditions may also contribute a variety of contaminants such as salt spray, dirt and duct, oil, fuel, acid, corrosive vapor and fungus. Although the list of possible contaminants is almost endless, in all but the most severe cases, their destructive action effectively can be eliminated by provision of a good conformal coating.

In addition to providing protection from contaminants, conformal coatings and pottings also provide a certain degree of protection to mechanical shock, vibration and tampering.

Various conformal coating and potting systems are known in the art and are available commercially. Each has its advantages and disadvantages. One such prior art conformal coating and potting system is based on acrylics. Acrylics make excellent coating and potting systems from a production standpoint because they readily may be applied by spraying, dipping or brushing. Acrylic coatings and pottings have desirable electrical and physical properties and are fungus resistant. Additional advantages of acrylic coatings and pottings include long life, low or no exotherm during cure, and little or no shrinkage during cure. However, acrylic coatings and pottings typically are formed by solvent evaporation and reach optimum physical characteristics during cure typically in a matter of minutes. Conventional acrylic coatings and pottings are soluble in chlorinated solvents such as trichloroethane or methylene chloride.

Another prior art conformal coating and potting system is based on polyurethanes. Polyurethanes are available as either single or two-component systems. Polyurethane coatings and pottings offer excellent humidity and chemical resistance and good dielectric properties. Single-component urethanes are relatively easy to apply and exhibit relatively long working pot life. However, single-component polyurethanes typically require a curing time of three to ten days at room temperature to reach optimum physical characteristics. Two-component polyurethanes typically achieve optimum cure at elevated temperatures within one to three hours, but exhibit relatively short working pot life. Also, surface preparation of substrate boards and components prior to application of polyurethane based coatings and pottings is important, since even minute quantities of moisture on a substrate board or component could produce blistering under humid conditions. Blisters, in turn, may lead to electrical failures and mandate costly rework. Polyurethane coatings and pottings are insoluble in most common solvents, which is a drawback to rework. Thus, repair of a polyurethane coated board or potted components requires a corrosive stripper to remove effectively all traces of the polyurethane film. However, extreme caution must be exercised when such a stripper is used, because the stripper also may corrode metallic surfaces on the board or component.

Epoxy resin systems also have been employed by the prior art for conformal coatings and pottings. Epoxy resins are available as two component systems only. Epoxy resin coatings and pottings provide good humidity resistance and high abrasive and chemical resistance. However, epoxy resins are virtually impossible to remove chemically for rework because any stripper that will attack the coating also will attack materials commonly used in making the electronic components and the epoxy-glass of printed circuit boards as well. Thus, the only effective way to repair an epoxy resin coated board or potted component is to burn through the epoxy coating with a hot knife or soldering iron. However, burning introduces a cosmetic defect which is unacceptable to many consumers. Moreover, epoxy resins shrink somewhat during cure. Accordingly, a buffer material must be placed around fragile electronic components to prevent fracturing from shrinkage. Curing of epoxy systems can be accomplished in one to three hours at elevated temperature, or four to seven days at room temperature. Epoxy resins exhibit a relatively short working pot life which is an additional disadvantage.

Silicone resins also have been employed by the prior art for conformal coating and pottings. Silicone resin coatings and pottings provide high humidity and corrosion resistance along with high temperature resistance which makes silicone resins preferred for coating and potting assemblies that contain high heat-dissipating components such as power resistors. However, silicone resins are relatively thick making them somewhat difficult to apply. Moreover, silicone resins require a relatively long cure, and repairability is difficult since silicone resins once cured are essentially insoluble, and cannot be vaporized with the heat of a soldering iron. Accordingly, the only effective way to repair a silicone resin coated circuit board or potted component is to mechanically remove the coating.

The prior art also has employed polyimides for conformal coatings and pottings. Polyimide coatings and pottings provide high-temperature, moisture and chemical resistance over extended periods of time. However, polyimide coatings require high temperature cure (one to three hours at 200 to 250 °C) which could damage heat sensitive electronic components, and this requirement severely limits the use of polyimide coating systems. Also, since polyimides are high-temperature, moisture and chemical resistant, the only effective way to repair a polyimide coated board or potted component is to mechanically remove the coating.

Diallyl phthalate varnishes also have been proposed by the prior art for conformal coatings and pottings, and provide excellent high temperature and chemical resistance. However, diallyl phthalate varnishes require high temperature cure (approximately 150 °C) which severely limits their use. And, diallyl phthalate coatings and pottings also typically must be mechanically removed to permit repair.

The preceeding discussion of background in the art of conformal coating circuit boards is taken largely from Printed Circuits Handbook, Clyde F. Coombs, Jr., Editor, McGraw Hill Book Company, Second Edition (1979).

US-A- 3396210 discloses polyisocyanate compositions comprising a homogeneous mixture of an isocyanate-terminated prepolymer selected from the class consisting of isocyanate-terminated polyhydric polyesters and isocyanate-terminated polyhydric polyalkylene ethers, said prepolymer having a molecular weight of 500 to 3,000 and from 1 to 100 percent by weight of said prepolymer of a polyunsaturated ester having the general formula:

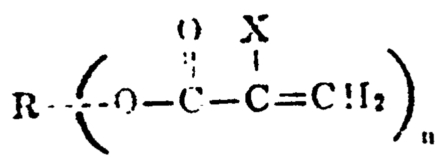

wherein R is an aliphatic hydrocarbon radical, X is a radical selected from the group consisting of hydrogen and methyl and *n* is from two to four. -

US 4 131 602 and US 4 174 307 disclose compositions which undergo a multistage reaction for the preparation of a reactive monomer wherein the diol and/or triol is first reacted with a polyisocyanate to create an intermediate product having terminal cyanato groups. This intermediate is then reacted under reaction conditions (see, for example, US 4 131 602 column 5, lines 1 through 15) with the hydroxy-acrylate of hydroxy methacrylate. The purpose of this reaction is to create an acrylated or methacrylated polyurethane compound. The resultant product contains no free urethane end groupings as they are all reacted with the hydroxy-acrylate, via the hydroxy groups, so as to create an acrylic or methacrylic terminated polyurethane compound. It is this acrylated or methacrylated polyurethane compound that is then mixed with a photoinitiator for preparation of a photo-curable composition.

As thus is apparent from the above discussion, none of the currently available conformal coatings and pottings are completely satisfactory since all prior art conformal coatings and pottings at best are a tradeoff of preferred application characteristics (i.e., processing speed, ease of application, pot life and cure conditions), preferred physical characteristics, (i.e., electrical properties, temperature, chemical and moisture resistance), and repairability.

It is thus a primary object of the present invention to provide an improved conformal coating and potting system, which overcomes the aforesaid and other disadvantages of the prior art.

Other objects of the present invention are to provide an improved composition for conformal coating printed circuit board assemblies and potting electrical and electronic components which compositions demonstrate extended pot life and ease of application, rapid dry-to-touch cure, good electrical properties, superior adhesion and abrasion resistance, excellent high temperature, chemical and moisture resistance, and ease of repairability.

Generally, the foregoing and other objects of the invention are achieved by the provision of an ultraviolet (hereinafter "uv") curable polymerizable coating and potting system having a secondary crosslinking curing mechanism built in. More specifically, the present invention provides a one-part coating

composition, especially useful for conformal coating and potting, characterized by comprising, in combination at least one isocyanate-capped polyether diol and triol which is formed by reacting a blend of one or more polyether diols and one or more polyether triols with an excess of diisocyanate; a mono or polyfunctional acrylate or methacrylate reactive diluent and a polymerization initiator of the photo-initiator type.

The present invention also provides a method of forming a UV curing polymerizable conformal coating or potting of a substrate wherein said substrate has one or more shadow areas, characterized by the steps in sequence of:

(1) providing at least one isocyanate-capped polyether diol and triol which is formed by reacting a blend of one or more polyether diols and one or more polyether triols with an excess of diisocyanate; a mono or polyfunctional acrylate or methacrylate reactive diluent and a polymerization initiator of the photoinitiator type;

(2) coating said substrate at least in part with said polymerizable composition;

(3) exposing said coated substrate to UV light of wave length and intensity to effect UV cure of the mono or polyfunctional acrylate or methacrylate reactive diluent in the exposed areas of said coating; and

(4) storing said coated substrate under conditions of temperature and humidity such as to promote moisture curing of unexposed (shadow) areas of said coating through a built-in secondary cure mechanism, namely the curing of the isocyanate-capped polyether diol and triol which is formed by reacting a blend of one or more I polyether diols and one or more polyether triols with an excess of diisocyanate.

A particular feature and advantage of the invention is that the UV radiation cure produces extremely rapid dry-to-the-touch cure of all exposed areas of the coating or potting thereby permitting substantially immediate handling of the coated products and maintenance of the shape of the coating which might otherwise sag and creep, while secondary curing which occurs by moisture reaction of the isocyanate capped prepolymer provides substantially complete cure of unexposed (shadow) areas of the coating or potting under conditions of ambient temperature and humidity.

For a fuller understanding of the nature and objects of the present invention, reference should be made to the following detailed description of the invention taken in connection with the accompanying examples.

The terms "liquid" and "solid" or "dry-to-the-touch" as used herein with reference to physical properties of the materials, are to be understood as to be referring to such properties as they exist under conditions as may be specified. For example, the term "liquid" refers to a physical state wherein a material is readily flowable while the terms "solid" and "dry-to-the - touch" are to be understood as referring respectively to physical states wherein a material is resistant to change in shape and is without free surface moisture of surface tackiness.

The isocyanate-capped prepolymers employed in the coating and potting system of the invention are formed by reacting a blend of one or more polyether diols and one or more polyether triols with an excess of at least one diisocyanate. The preferred polyether diols are selected from those having a molecular weight in the range of about 300 to about 5000, while the preferred polyether triols are selected from those having a molecular weight in the range of about 200 to about 3000. Particularly preferred is a blend of polyether diols having a molecular weight in the range of about 400 to about 1000, and polyester triols having a molecular weight of about 700.

The polyether diol/polyether triol blend typically comprises the polyether diol in substantial major proportion, e.g. seventy or more by weight of the polyether diol, while the polyether triol may be present in quite minor amount, e.g. as little as one to three percent of the polyether triol. The preferred diisocyanate is toluene diisocyanate (TDI) although other relatively low molecular weight diisocyanates of the general formula:

(I) $(O = C = N)_2R$

wherein R is a $C_{2-20}$ alkylene, alkenylene or cycloalkylene radical or a $C_{6-40}$ arylene, alkarylene or aralkylene are useful.

The polyether diol-polyether triol blend is reacted with excess diisocyanate. Generally the equivalent weight reaction ratio of the polyether diol/polyether triol blend to diisocyanate will be in the range of about 1.0 equivalent weights of polyether diol/polyether triol to about 1.6 to about 2.2 equivalent weight of diisocyanate. The preferred reaction ratio is 1.0 equivalents of the polyether diol/polyether triol blend for every 2.0 equivalents of diisocyanate. This preferred reaction ratio is particularly important to the properties of the final composition. The 2:1 ratio yields a final product with a chemical structure having a high degree of chemical, solvent and hydrolytic resistance.

At present the preferred prepolymer is based on a mixture of 0.916 equivalents of polyether diol (m.w. 1000 average) and 0.084 equivalents of polyether triol (m.w. 700 average) reacted with 2.0 equivalents of diphenylmethane diisocyanate (MDI). The resin resulting is then blended with an acrylate or methacrylate reactive diluent such as are exemplified by, but not limited to trimethylol propane ethoxylate triacrylate, dicyclopentadiene methacrylate and dicyclopentadiene acrylate. Other reactive methacrylate compounds such as isobutyl methacrylate, isobornyl methacrylate, lauryl methacrylate and cyclohexylomethacrylate also can be beneficially utilized. The reaction preferably is accomplished in the absence of other i.e. non-reactive diluents.

The isocyanate-capped prepolymers typically comprise about 50 to about 75% by weight of the reaction mixture, and preferably will comprise about 65% by weight, while the acrylate or methacrylate reactant diluent typically will comprise about 25 to about 50% by weight of the reaction mixture, and preferably will comprise about 35% by weight.

The polymerization initiators useful in accordance with the present invention preferably comprise ultra-violet (hereafter "uv") activated free-radical generators and typically may be employed in amounts of about 1% to about 10% by weight of the coating and potting composition, although greater or lesser amounts of polymerization initiators may be employed. Many uv activated polymerization initiators are known in the art and may be advantageously employed in the invention. For example, the uv activated initiators may be selected from metal carbonyls of the formula $M_x(CO)_y$ wherein M is a metal atom, x is 1 or 2, and y is an integer determined by the total valence of the metal atoms, generally 4 to 10. The preferred uv activated initiators are selected from (a) $C_{1-16}$ straight or branched chain alkyl diones: and (b) carbonyl compounds of the general formula $R^5(CO)R^6$ wherein $R^5$ is a $C_{1-10}$ alkyl, aryl, aralkyl or alkaryl group, and $R^6$ is $R^5$ or hydrogen. In addition, $R^5$ or $R^6$ can contain any substituents which do not adversely affect the compound in serving its function. For example, $R^5$ or $R^6$ can be alpha-substituted with an alkyl, aryl, alkaryl, alkoxy or aryloxy radical, or with an amino or a mono-or dialkylamino derivative thereof, each of the above substitutents containing up to six carbon atoms. In addition, $R^5$ and $R^6$ taken together with carbonyl group form an aromatic or heterocyclic ketone containing up to about 16 carbon atoms.

It is useful, but not required to incorporate an adhesion promoter into the coating and potting system. The adhesion promoters may be chosen from any of those commonly known to the person reasonably skilled in the art. Two types of promoters are preferred. The first type consists of mono-and dicarboxylic acids which are capable of copolymerizing with the acrylate or methacrylate reactive diluent. The preferred species of these classes are methacrylic and acrylic acid. Such acids are used in proportions of 1-20% by weight of coating and potting system, preferably in proportion of 1-10 to 1-15%. The second preferred type of adhesion promoter is of the well-known silane type, present in the composition in proportions of 1-10% by weight of the coating and potting system.

Also optional, but recommended, are the inclusion of one or more chelators, cross-linking agents and/or polymerization inhibitors. Chelators and inhibitors are effective in amounts of about 0.1 to about 1% by weight of the coating and potting system. Ethylenediamine tetra-acetic acid and its sodium salt ($Na_4$EDTA), 1,1-ethylenebis-nitril methylidyne dipyridine and the class of beta-diketones are generally the most effective and are preferred. Cross-linking agents, optionally present in amounts from about zero to about 10% by weight of the coating and potting system, include such compounds as copolymerizable dimethyacrylates.

The inhibitor concentration left over in the monomers from manufacture is often high enough for good stability. However, to ensure maximum shelf life, the proportions mentioned above (about 0.1 to about 1% by weight of the coating and potting system) are recommended. Of those inhibitors which have been found of adequate utility is the group consisting of hydroquinones, benzoquinones, naphthoquinones, phenanthraquinones, anthraquinones, and substituted compounds of any of the foregoing. Additionally, various phenols can be employed as inhibitors, the preferred one being 1,6-di-tert-butyl-4-methyl phenol.

The amount of thickness, viscosity or thixotropy desired can be varied in accordance with the particular application required. Thickeners, plasticizers, diluents, and various other reagents common to the art can be employed in any reasonable manner to produce the desired characteristics.

It also is optional, but recommended, that surfactants be present in the coating and potting system for optimum performance. Selection of suitable surfactants is a matter of simple experimentation. Obviously the surfactant must be soluble in the polymer composition and should be non-reactive with the isocyanate-capped prepolymer. The surfactants may be anionic materials such as the petroleum sulfonates having the formula:

(VIII) $(C_nH_{2n-10}SO_3)_xMe$

wherein n is more than 20 and Me is a metal of valence x. Such materials are sold by, among others, Witco

Chemical Corp., New York, New York, under the trademark "Alconate" 80, and by the Penreco Division of Penzoil, Butler, Pennsylvania, under the trademark "Petrobase."

Another suitable anionic type comprises the sodium alkyl or alkylaryl sulfonates having the formula:

(IX) 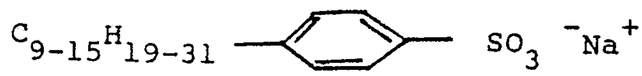

Such materials are sold by E.I. duPont de Nemours & Co., Wilmington, Delaware, under the trademarks "Alkanol" 189-S and "DW" and the trademark "Duponol," and by Union Carbide Corp., New York, New York, under the trademark "Tergitol" (numerical series). Still another useful anionic class is the sulfonated ethoxylated types sold as the "Alipal" series by GAF Corp., New York, New York, and as "Neodol" 25-35 by Shell Chemical Co., Houston Texas.

Non-ionic surfactants such as Union Carbide L-5320 also may be usefully employed in the inventive compositions.

Surfactant concentration will depend in any given case upon the particular surfactant and reactive diluent being used. Optimization will be a matter of routine experimentation within the skill of the art. Ordinarily, for anionic surfactants, however, minimum concentration of about 0.25 percent surfactant by weight of the coating and potting system will be needed to achieve an acceptable degree of emulsifiability, and a concentration of at least about 0.5 percent usually will be preferred. The maximum surfactant concentration will usually be about ten percent since above this level the surfactant may begin to interfere with the properties of the coating and potting system by adversely affecting, for example, its cure rate, stability or the cured products. As a practical matter, an upper concentration limit of about five percent, is usually satisfactory. For non-ionic surfactants, the optimum concentration may be lower, typically around 0.1% or less by weight of the total coating and potting system.

It is frequently desirable to add low levels, such as up to about 500 parts per million by weight, of a free-radical or uv stabilizer, many of which are known in the art, to prevent spurious polymerization of the composition prior to the time of its intended use. Suitable free-radical stabilizers are hydroquinone, p-benzoquinone, butylate of hydroxytoluene, and butylate of hydroxyanisole.

The coating and potting systems of the present invention are designed primarily as a uv curing product; however, due to the configuration of many circuit boards and electrical and electronic components there are shadow areas that cannot be cured by uv light. To overcome this deficiency, a second curing mechanism has been built into the coating and potting system. More specifically, in accordance with the invention, after exposure to uv a built-in moisture cure mechanism is available to complete curing of uncured areas of the coating and potting. The overall curing mechanisms of the invention are as follows:

(1) uv light polymerizes the acrylate or methacrylate species to provide fixture of the coating or potting; and

(2) the isocyanate-capped prepolymer then reacts with water, specifically atmospheric moisture, i.e. according to the following formula:

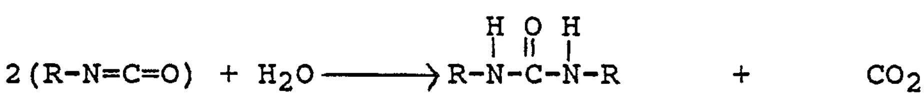

This latter reaction provides ultimate physical properties and complete cure to the substrate of unexposed areas of the coating or potting in twenty-four hours or less.

## Example 1

This invention will now be illustrated by the following description of specific preferred embodiments thereof, given by way of example only. To a nitrogen-swept, four-necked uv shielded resin kettle equipped with a stainless steel stirrer, nitrogen inlet tube, thermometer, condensor and entrance port, add 286 grams of ICI LF-168 modified 4,4'-diphenylmethane diisocyanate. Then slowly add at 60° with mixing 466 grams of polyether diol (1000 m.w. average) and 20 grams of polyether triol (700 m.w. avarage). Heat to 60° C with mixing for one hour and then at 90° C for one and one half hours. Cool to room temperature, add 260 grams of trimethylol propane ethoxylate triacrylate and 30 grams of Ciba-Geigy Irgacure 651 dimethoxy-2-phenyl acetophenone, and blend.

The resulting blend was applied by dipping the back side surface of an audio speaker cone. Cure of the coating was effected by exposing the speaker to uv radiation (3650 angstroms, 60000 microwatts per square centimeter) for 20 seconds. Those areas of the coating exposed to uv radiation were solid and dry to the touch within 25 to 45 seconds. Shadow areas of the speaker cone, i.e. not receiving direct uv radiation, were wet to the touch initially, but were found to be fully cured after standing at ambient temperature and humidity conditions for twenty-four hours. The speaker cone was sliced through shadow areas and the coating was found to be fully cured to the board surface after twenty-four hours.

The coating was humidity tested as follows: The coated speaker cane was placed on a rack in a stainless steel tank, and 500 grams of water added to the bottom of the tank. The tank was closed, sealed, and heated to a temperature of 15° C. After heating for 40 hours, the tank was allowed to cool. The tank was then opened, and the cone removed and examined. No visible blistering or other evidence of coating failure was observed.

EXAMPLE II

The procedure of Example I was repeated except 260 grams of dicyclopentenyl methacrylate was employed in place of the trimethylol propane ethoxylate triacrylate. Similar results to Example I were obtained.

EXAMPLE III

The procedure of Example II was repeated except 260 grams of dicyclopentadiene acrylate was employed in place of the trimethylol propane ethoxylate triacrylate. Similar results to Example I were obtained.

As will be appreciated the foregoing invention provides novel and improved coating systems for conformal coating and potting printing circuit boards and electrical and electronic components and the like. The coating and potting systems may be applied to the circuit board substrates or components by any convenient manner, for instance by brushing, dripping, rolling, dipping, etc. or by spraying (when suitably diluted). Moreover, the coating and potting cure through dual mechanisms including uv cure which permits fast fixture cure thereby achieving almost immediate dry-to-the-touch curing. However, unlike conventional uv cured products, the coating and potting systems of the present invention do not require full area irradiation to achieve full cure due to their built-in secondary cure mechanism. Moreover, the cured coatings and pottings have excellent adherence to plastics, metal, glass and wood, good abrasion resistance, and are hydrolytically stable, and resistant to thermal cycling. The coating and pottings also are repairable, i.e., can be removed by selective solvents such as methyl ethyl ketone, and then replaced by brush or spray, and uv cured.

The invention has been described particularly with application to conformal coating circuit board assemblies and to potting audio speaker cones. However, one skilled in the art would appreciate that the coating and potting systems may be applied to other electrical electronic components such as electrical transformers or the like. Moreover, the coating and potting system is not limited to the use in the electronics field but may be employed im any industrial area where conformal protective coating and/or potting is desired.

## Claims

1. A one-part coating composition, especially useful for conformal coating and potting, characterized by comprising, in combination at least one isocyanate-capped polyether diol and triol which is formed by reacting a blend of one or more polyether diols and one or more polyether triols with an excess of diisocyanate; a mono or polyfunctional acrylate or methacrylate reactive diluent and a polymerization initiator of the photo-initiator type.

2. The composition of Claim 1, characterized in that said isocyanate-capped polyether diol and triol comprises the reaction product of a blend of at least one polyether diol and at least one polyether triol with excess diisocyanate.

3. The composition of Claim 2, characterized by one or more of the following features:
(a) the polyether diol portion comprises a polyether diol of molecular weight in the range of about 300 to about 5000 average;
(b) the polyether triol portion comprises a polyether triol of molecular weight in the range of about 200 to about 3000 average;
(c) said polyether diol has a molecular weight of about 400 to about 1000 average, and said polyether triol has a molecular weight of about 700 average;
(d) said polyether diol and polyether triol blend comprises said polyether diol in major proportion;
(e) said isocyanate-capped polyether diol and triol comprises the reaction product about 1.0 equivalents of said polyether diol and polyether triol blend with about 1.6 to about 2.2 equivalents of diisocyanate, more preferably about 1.0 equivalents of said polyether diol and polyether triol blend with about 2.0 equivalents of diisocyanate;
(f) said acrylate or methacrylate reactive diluent is selected from trimethylol propane ethoxylate triacrylate, dicyclopentadiene methacrylate, dicyclopentadiene acrylate, isobutyl methacrylate, isobornyl methacrylate, lauryl methacrylate and cyclohexylmethacrylate; and
(g) said acrylate or methacrylate reactive diluent comprises about 25 to about 50% by weight of said composition; more preferably about 35% by weight of said composition.

4. The composition of any of Claims 1 to 3, characterized by further comprising a surfactant.

5. A method of forming a UV curing polymerizable conformal coating or potting of a substrate wherein said substrate has one or more shadow areas, characterized by the steps in sequence of:
(1) providing at least one isocyanate-capped polyether diol and triol which is formed by reacting a blend of one or more polyether diols and one or more polyether triols with an excess of diisocyanate; a mono or polyfunctional acrylate or methacrylate reactive diluent and a polymerization initiator of the photoinitiator type;
(2) coating said substrate at least in part with said polymerizable composition;
(3) exposing said coated substrate to UV light of wave length and intensity to effect UV cure of the mono or polyfunctional acrylate or methacrylate reactive diluent in the exposed areas of said coating; and
(4) storing said coated substrate under conditions of temperature and humidity such as to promote moisture curing of unexposed (shadow) areas of said coating through a built-in secondary cure mechanism, namely the curing of the isocyanate-capped polyether diol and triol which is formed by reacting a blend of one or more polyether diols and one or more polyether triols with an excess of diisocyanate.

6. A method according to Claim 5 , characterized in that said substrate comprises as electrical or electronic component, if desired mounted on a circuit board and overshadowing areas of said circuit board.

7. An electrical or electronic component, if desired mounted on a circuit board, and covered at least in part with the cured composition of any of claims 1 to 3.

## Revendications

1. Composition de revêtement en une seule partie, particulièrement utile pour le revêtement et l'encapsulation épousant les formes, caractérisée en qu'elle comprend, en association, au moins un polyéther diol et triol coiffé par un isocyanate qui est formé en faisant réagir un mélange d'un ou plusieurs polyéthers diols et d'un ou plusieurs polyéthers triols avec un accès de diisocyanate ; un acrylate ou méthacrylate mono- ou polyfonctionnel comme diluant réactif et un agent d'amorçage de polymérisation du type photoinitiateur.

2. Composition selon la revendication 1, caractérisée en ce que ce polyéther diol et triol coiffé par un isocyanate comprend le produit de la réaction d'un mélange d'au moins un polyéther diol et d'au moins un polyéther triol avec un excès de diisocyanate.

3. Composition selon la revendication 2, caractérisée par une ou plusieurs des caractéristiques suivantes :

(a) la partie polyéther diol comprend un polyéther diol d'une masse moléculaire dans l'intervalle d'environ 300 à environ 5 000 en moyenne ;
(b) la partie polyéther triol comprend un polyéther triol ayant une masse moléculaire dans l'intervalle d'environ 200 à environ 3 000 en moyenne ;
(c) ce polyéther diol a une masse moléculaire d'environ 400 à environ 1 000 en moyenne, et ce polyéther triol a une masse moléculaire d'environ 700 en moyenne ;
(d) ce mélange de polyéther diol et de polyéther triol comprend une proportion prédominante de ce polyéther diol ;
(e) ce polyéther diol et triol coiffé par un isocyanate comprend le produit de la réaction d'environ 1,0 équivalent de ce mélange de polyéther diol et de polyéther triol avec environ 1,6 à environ 2,2 équivalent de diisocyanate, de préférence environ 1,0 équivalent de ce mélange de polyéther diol et de polyéther triol avec environ 2,0 équivalent de diisocyanate ;
(f) ce diluant réactif à base d'acrylate ou de méthacrylate est choisi parmi l'éthoxylate triacrylate de triméthylol propane, le méthacrylate de dicyclopentadiène, l'acrylate de dicyclopentadiène, le méthacrylate d'isobutyle, le méthacrylate d'isobornyle, le méthacrylate de lauryle et le méthacrylate de cyclohéxyle ; et
(g) ce diluant réactif à base d'acrylate ou de méthacrylate constitue environ 25 à environ 50 % en poids de cette composition ; de préférence environ 35 % en poids de cette composition.

**4.** Composition selon l'une quelconque des revendications 1 à 3, caractérisée en ce qu'elle contient en outre un agent tensioactif.

**5.** Procédé de formation d'un revêtement ou d'une encapsulation épousant les formes d'un substrat, polymérisable par les UV, dans lequel ce substrat a une ou plusieurs zones d'ombres, caractérisé par les étapes successives consistant à :
(1) réaliser au moins un polyéther diol et triol coiffé par un isocyanate qui est formé en faisant réagir un mélange d'un ou plusieurs polyéthers diols et d'un ou plusieurs polyéthers triols avec un excès de diisocyanate ; un diluant réactif à base d'acrylate ou de méthacrylate mono- ou polyfonctionnel et un agent d'amorçage de polymérisation du type photoinitiateur ;
(2) revêtir ce substrat au moins en partie de cette composition polymérisable ;
(3) exposer ce substrat revêtu à une lumière UV d'une longueur d'onde et d'une intensité permettant d'effectuer le durcissement par les UV du diluant réactif à base d'acrylate ou de méthacrylate mono- ou polyfonctionnel dans les zones exposées de ce revêtement ; et
(4) stocker ce substrat revêtu dans des conditions de température et d'humidité favorisant le durcissement par l'humidité des zones non exposées (ombre) de ce revêtement par un mécanisme de durcissement secondaire incorporé, à savoir le durcissement du polyéther diol et triol coiffé par un isocyanate qui est formé en faisant réagir un mélange d'un ou plusieurs polyéthers diols et d'un ou plusieurs polyéthers triols avec un excès de diisocyanate.

**6.** Procédé selon la revendication 5, caractérisé en ce que ce substrat comprend un composant électrique ou électronique, monté si on le désire sur une plaque de circuit imprimé et en ce qu'on ombre certaines zones de cette plaque de circuit imprimé.

**7.** Composant électrique ou électronique, monté si on le désire sur une plaque de circuit imprimé, et recouvert au moins en partie de la composition durcie selon l'une quelconque des revendications 1 à 3.

**Ansprüche**

**1.** Einkomponenten-Beschichtungs-Zusammensetzung, insbesondere zum konformen Beschichten und Vergießen, dadurch gekennzeichnet, daß sie in Kombination mindestens ein endständige Isocyanatgruppen aufweisendes Polyetherdiol und -triol, das durch Umsetzen einer Mischung eines oder mehrerer Polyetherdiole und eines oder mehrerer Polyethertriole mit einem Überschuß an Diisocyanat gebildet wird, ein reaktives mono- oder polyfunktionelles Acrylat- oder Methacrylat-Verdünnungsmittel sowie einen Polymerisationsinitiator von der Art eines Photoinitiators umfaßt.

**2.** Zusammensetzung nach Anspruch 1, dadurch gekennzeichnet, daß das endständige Isocyanatgruppen aufweisende Polyetherdiol und -triol das Produkt der Umsetzung einer Mischung mindestens eines

Polyetherdiols und mindestens eines Polyethertriols mit überschüssigem Diisocyanat umfaßt.

3. Zusammensetzung nach Anspruch 2, gekennzeichnet durch eines oder mehrere der folgenden Merkmale:
   (a) Der Polyetherdiol-Anteil umfaßt ein Polyetherdiol mit einem mittleren Molekulargewicht im Bereich von etwa 300 bis etwa 5000;
   (b) der Polyethertriol-Anteil umfaßt ein Polyethertriol mit einem mittleren Molekulargewicht im Bereich von etwa 200 bis etwa 3000;
   (c) das Polyetherdiol besitzt ein mittleres Molekulargewicht von etwa 400 bis etwa 1000 und das Polyethertriol besitzt ein mittleres Molekulargewicht von etwa 700;
   (d) das Gemisch aus Polyetherdiol und Polyethertriol enthält das Polyetherdiol als Hauptanteil;
   (e) das endständige Isocyanatgruppen aufweisende Polyetherdiol und -triol umfaßt das Reaktionsprodukt aus etwa 1,0 Äquivalenten der Polyetherdiol und Polyethertriol-Mischung und etwa 1,6 bis etwa 2,2 Äquivalenten Diisocyanat, vorzugsweise aus etwa 1,0 Äquivalenten der Polyetherdiol und Polyethertriol-Mischung und etwa 2,0 Äquivalenten Diisocyanat;
   (f) das reaktive Acrylat- oder Methacrylat-Verdünnungsmittel ist ausgewählt aus: Trimethylolpropan-ethoxylat-triacrylat, Dicyclopentadien-methacrylat, Dicyclopentadien-acrylat, Isobutylmethacrylat, Isobornylmethacrylat, Laurylmethacrylat und Cyclohexylmethacrylat; und
   (g) das reaktive Acrylat- oder Methacrylat-Verdünnungsmittel umfaßt etwa 25 bis etwa 50 Gew.-% der Zusammensetzung, vorzugsweise etwa 35 Gew.-% der Zusammensetzung.

4. Zusammensetzung nach einem der Ansprüche 1 bis 3, dadurch gekennzeichnet, daß sie zusätzlich ein oberflächenaktives Mittel umfaßt.

5. Verfahren zur Bildung einer UV-härtenden, polymerisierbaren, konformen Beschichtung bzw. eines Vergusses eines Substrats, bei dem das Substrat einen oder mehrere abgeschattete Bereiche aufweist, gekennzeichnet durch die aufeinanderfolgenden Verfahrensschritte:
   (1) Es wird mindestens ein endständige Isocyanatgruppen aufweisendes Polyetherdiol und -triol bereitgestellt, das durch Umsetzen einer Mischung eines oder mehrerer Polyetherdiole und eines oder mehrerer Polyethertriole mit einem Überschuß an Diisocyanat gebildet wird, sowie ein reaktives, mono- oder polyfunktionelles Acrylat- oder Methacrylat-Verdünnungsmittel und ein Polymerisationsinitiator von der Art eines Photoinitiators;
   (2) das Substrat wird mindestens teilweise mit der polymerisierbaren Zusammensetzung beschichtet;
   (3) das beschichtete Substrat wird mit UV-Licht einer solchen Wellenlänge und Intensität bestrahlt, daß die UV-Härtung des reaktiven mono- oder polyfunktionellen Acrylat- oder Methacrylat-Verdünnungsmittels in den belichteten Bereichen der Beschichtung bewirkt wird; und
   (4) das beschichtete Substrat wird unter solchen Bedingungen hinsichtlich der Temperatur und der Feuchtigkeit gelagert, daß die feuchtigkeitsinduzierte Härtung der nicht belichteten (abgeschatteten) Bereiche der Beschichtung mittels eines eingebauten sekundären Härtungsmechanismus beschleunigt wird, nämlich die Härtung des endständige Isocyanatgruppen aufweisenden Polyetherdiols und -triols, das durch Umsetzen einer Mischung eines oder mehrerer Polyetherdiole und eines oder mehrerer Polyethertriole mit einem Überschuß an Diisocyanat gebildet wird.

6. Verfahren nach Anspruch 5, dadurch gekennzeichnet, daß das Substrat ein elektrisches oder elektronisches Bauelement, gegebenenfalls auf eine Leiterplatte montiert und Bereiche der Leiterplatte abschattend, umfaßt.

7. Elektrisches oder elektronisches Bauteil, gegebenenfalls auf eine Leiterplatte montiert, das mindestens teilweise mit der gehärteten Zusammensetzung gemäß einem der Ansprüche 1 bis 3 beschichtet ist.